# DEMANDE DE BREVET EUROPEEN

(11) **EP 3 276 769 A1**
(43) Date de publication de la demande: **31.01.2018**
(21) Numéro de dépôt: 17176865.8
(22) Date de dépôt: 20.06.2017
(51) Int. Cl.: H02J 3/04

(54) **DISPOSITIF DE CONTRÔLE-COMMANDE D'UN INVERSEUR DE SOURCES**

(30) Priorité: 27.07.2016 FR 1657195
(71) Demandeur: Schneider Electric Industries SAS, 92500 Rueil-Malmaison (FR)
(72) Inventeur: RET, Alain, 38050 GRENOBLE Cedex 09 (FR)
(74) Mandataire: Tripodi, Paul

(57) **Abrégé**

Dispositif destiné au contrôle-commande de commutateurs (4, 5) agencés pour connecter au moins deux source d'énergie électrique (1, 2) à une charge électrique (8) en fonction de la disponibilité desdites sources, et comportant :
- des circuits de contrôle-commande,
- un bus d'alimentation (63),
- un premier (61) et un deuxième (62) convertisseur de tension agencés pour convertir respectivement une première tension (Us1) de la première source d'énergie (1) et une seconde tension (Us2) et de la seconde source d'énergie (2) en une tension intermédiaire (Ui) pour alimenter le bus d'alimentation (63),
- un troisième convertisseur de tension (64) agencé pour convertir la tension (Ui) du bus d'alimentation en une tension d'utilisation (Uc) pour alimenter les circuits de contrôle-commande.

L'invention concerne également un inverseur de sources comportant un tel dispositif ainsi qu'un procédé pour l'alimentation du dispositif de contrôle-commande.

## Description

### DOMAINE TECHNIQUE

L'invention concerne un dispositif destiné au contrôle-commande d'au moins un premier et un second commutateurs agencés pour connecter respectivement au moins une première et une seconde source d'énergie électrique à une charge électrique en fonction de la disponibilité desdites sources.

L'invention concerne aussi un inverseur de sources destiné à connecter respectivement une première et une seconde source d'énergie électrique à une charge électrique en fonction de la disponibilité desdites sources.

L'invention concerne également un procédé pour l'alimentation d'un dispositif destiné au contrôle-commande d'un inverseur de sources.

### ETAT DE LA TECHNIQUE

La disponibilité de l'énergie électrique est importante, entre autres pour les hôpitaux, pour les industries de production ne supportant pas les arrêts intempestifs ou pour les installations fonctionnant avec de gros moyens informatiques. En effet, une coupure d'alimentation en énergie électrique peut générer des dégâts importants : perte de production, perte de données et pire perte de vie humaine.

Pour éviter de telles conséquences, un dispositif appelé généralement inverseur de sources est utilisé : dès que la source principale d'énergie n'est plus disponible, l'inverseur de sources commute automatiquement l'arrivée de l'énergie électrique sur une seconde source d'énergie disponible. Cette seconde source est généralement un groupe électrogène mais peut être une ligne électrique différente ou une sortie d'un transformateur redondant de l'installation électrique. Par ailleurs, il est de plus en plus fréquent de disposer de plusieurs autres sources d'énergie afin de pallier toute défaillance de la seconde source, par exemple un non démarrage du groupe électrogène ou des opérations de maintenance de ligne électrique.

La seconde source fournit l'énergie tant que la source principale est indisponible.

Quand celle-ci redevient disponible, en règle générale, l'inverseur de sources déconnecte la seconde source pour reconnecter automatiquement l'utilisateur sur la source principale. Selon le besoin de l'utilisateur, d'autres modes de transition vers un retour à une situation normale peuvent exister.

La sûreté de fonctionnement et la sécurité des biens et/ou des personnes étant en jeu, le fonctionnement de l'inverseur de sources doit être fiable et sans dysfonctionnement : par exemple, il est interdit de connecter simultanément deux ou plusieurs sources désynchronisées afin d'éviter des surintensités et des variations de tension inacceptables. Pour cela, par exemple dans les inverseurs les plus simples ne comportant que deux sources, la commande d'un des commutateurs est reliée en série avec un capteur d'état de l'autre commutateur et réciproquement afin d'assurer un auto-verrouillage électrique des commutateurs.

Cependant, dès que l'installation comporte plus de deux sources, la complexité de câblage devient plus importante, avec des risques de mauvais câblage lors du montage de l'inverseur de source.

Cette complexité s'accroit encore lorsque la puissance de l'installation électrique dépasse plusieurs centaines d'ampères : les commutateurs utilisés peuvent être des disjoncteurs de puissance assurant la fonction complémentaire de protection contre les courts-circuits. Ces disjoncteurs de puissance ont un fonctionnement plus complexe que de simples contacteurs, en particulier leur manoeuvre nécessite une étape de réarmement entre l'ouverture et la fermeture, ils peuvent être embrochés ou débrochés pour des opérations de maintenance. Les auxiliaires indiquant leur état sont donc plus nombreux que dans le cas d'un simple contacteur.

Par ailleurs, l'isolement électrique entre les différentes sources et leurs auxiliaires doit être garanti afin d'éviter un bouclage intempestif entre le circuit de la source principale et le circuit de la seconde source, pouvant être à l'origine de grave court-circuit entre les sources.

De plus, les installations électriques devant être adaptées au développement de l'activité et la disponibilité de l'énergie étant de plus en plus demandée par les utilisateurs, il est nécessaire de pouvoir faire évoluer facilement un inverseur de sources sans risque pour les biens et les personnes.
Enfin, en cas de défaillance de fourniture d'énergie, il devient vital de pouvoir diagnostiquer l'origine du défaut afin d'y remédier le plus rapidement possible.

On connait le document FR 3 026 245 décrivant un dispositif d'interconnexion destiné à sécuriser et faciliter le raccordement dans un inverseur de source. Ce dispositif comporte un pré-câblage facilitant l'interconnexion des commutateurs et du boitier de contrôle-commande de l'inverseur de source. Bien qu'apportant une réponse au problème de la simplification du câblage et de la réduction du risque d'erreur de câblage, le dispositif d'interconnexion ne permet pas facilement l'intégration d'une troisième source d'énergie puisque, dans ce cas, il faudra réaliser de nouveaux faisceaux de câblage.

On connait le document US 7 259 481 décrivant un inverseur de sources capable de s'adapter à une large plage de variation de tension délivrée par la seconde source. Il est adapté à un réseau électrique comportant uniquement deux sources et ne dispose pas de séparation galvanique entre les deux sources. La défaillance d'une diode dans l'étage redresseur peut créer une liaison accidentelle entre le circuit de la source principale et le circuit de la seconde source conduisant à un court-circuit entre les deux sources. D'autre part, l'invention est dédiée à une installation de puissance réduite : le relais utilisé pour commuter les sources n'est pas adapté pour une installation industrielle de forte puissance utilisant de commutateurs de puissance ayant des modes d'ouverture et fermeture en plusieurs étapes. Enfin, il ne permet pas facilement l'intégration d'une troisième source, le relais utilisé n'ayant que deux états possibles.

### EXPOSE DE L'INVENTION

Afin de remédier aux inconvénients précités de l'état de la technique, l'invention propose un dispositif destiné au contrôle-commande d'au moins un premier et un second commutateurs agencés pour connecter respectivement au moins une première et une seconde source d'énergie électrique à une charge électrique en fonction de la disponibilité desdites sources, ledit dispositif comportant :
- un circuit de pilotage,
- des circuits de contrôle-commande,
- un bus d'alimentation,
- un premier convertisseur de tension comportant une entrée reliée à la première source d'énergie et une sortie connectée au bus d'alimentation, et agencé pour convertir une première tension de la première source d'énergie en une tension intermédiaire pour alimenter le bus d'alimentation,
- un deuxième convertisseur de tension comportant une entrée reliée à la seconde source d'énergie et une sortie connectée au bus d'alimentation, et agencé pour convertir une seconde tension de la seconde source d'énergie en une tension intermédiaire pour alimenter le bus d'alimentation,
- un troisième convertisseur de tension agencé pour convertir la tension intermédiaire du bus d'alimentation en une tension d'utilisation pour alimenter les circuits de contrôle-commande.

Préférentiellement, les circuits de contrôle-commande comportent :
- un circuit de commande de l'activation des commutateurs et/ou
- un circuit de contrôle de l'état des commutateurs et/ou
- un circuit de détermination de la disponibilité des sources.

De préférence, les premier et deuxième moyens de conversion comportent une isolation galvanique entre respectivement la première source d'énergie électrique et le bus d'alimentation, et entre la seconde source d'énergie électrique et le bus d'alimentation.

Préférentiellement le premier convertisseur de tension effectue la conversion de la première tension de la première source d'énergie en une tension intermédiaire lorsque la première tension est supérieure à un premier seuil. De façon identique, le deuxième convertisseur de tension effectue la conversion de la seconde tension de la seconde source d'énergie en une tension intermédiaire lorsque la seconde tension est supérieure à un second seuil.

Avantageusement la tension intermédiaire est une tension continue.

De préférence, la tension d'utilisation est sensiblement égale à la tension nominale de fonctionnement des circuits de contrôle-commande.

Avantageusement, un dispositif d'alimentation de secours est connecté au bus d'alimentation pour délivrer la tension intermédiaire audit bus d'alimentation quand la première et la seconde source d'énergie sont indisponibles.

Avantageusement le dispositif d'alimentation de secours comporte un moyen de stockage d'énergie agencé pour être chargé sous une tension de stockage quand la première et/ou la seconde source d'énergie est disponible.

Selon un mode de réalisation préféré, la tension intermédiaire est sensiblement égale à la tension de stockage du moyen de stockage d'énergie du dispositif de secours.

Préférentiellement le circuit de pilotage est connecté au bus d'alimentation pour son alimentation.

L'invention a également pour objet un inverseur de sources destiné à connecter respectivement une première ou une seconde source d'énergie électrique à une charge électrique en fonction de la disponibilité desdites sources, ledit inverseur de source comportant :
- au moins un premier et un second commutateurs,
- au moins deux auxiliaires de commande, chaque auxiliaire étant destiné à commander respectivement un commutateur,
- un ou plusieurs capteurs d'état, chaque capteur d'état coopérant respectivement avec un commutateur pour détecter l'état dudit commutateur, et
- un dispositif de contrôle-commande comportant une ou plusieurs des caractéristiques décrites précédemment.

Préférentiellement, l'entrée des premiers moyens de conversion est connectée entre la première source et le premier commutateur, et l'entrée des seconds moyens de conversion est connectée entre la seconde source et le second commutateur.

L'invention porte également sur un procédé pour l'alimentation d'un dispositif destiné au contrôle-commande d'un inverseur de sources comportant une ou plusieurs des caractéristiques décrites précédemment, ledit procédé comprenant les étapes suivantes :
- la conversion de la première tension de la première source d'énergie en tension intermédiaire pour alimenter le bus d'alimentation au moyen d'un premier convertisseur de tension,
- la conversion de la seconde tension de la seconde source d'énergie en tension intermédiaire pour alimenter le bus d'alimentation au moyen d'un deuxième convertisseur de tension,
- la conversion de la tension du bus d'alimentation en une tension d'utilisation au moyen d'un troisième convertisseur de tension.

Le procédé comporte en outre les étapes suivantes en cas de présence d'un dispositif d'alimentation de secours :
- la fourniture par le dispositif d'alimentation de secours de la tension intermédiaire au bus d'alimentation quand les deux moyens de conversion de la première tension ou de la seconde tension ne fonctionnent pas, sinon,
- la recharge du moyen de stockage du dispositif d'alimentation de secours quand la tension intermédiaire est fournie par au moins un des moyens de conversion de la première tension ou de la seconde tension.

Ainsi, tous les auxiliaires des commutateurs sont alimentés par une tension d'utilisation unique, isolée galvaniquement et indépendante des différentes sources d'énergie, d'amplitude stable et maîtrisée. Cette disposition permet une simplification du schéma de câblage des auxiliaires et par conséquent minimise les risques d'erreur de câblage, tout en permettant une extension facile à des sources d'énergie supplémentaires.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 est une représentation schématique d'une installation électrique comportant un inverseur de sources ;
- la figure 2 est une représentation schématique d'un dispositif inverseur de sources mis en oeuvre dans l'art antérieur ;
- la figure 3 est une représentation schématique d'un dispositif inverseur de sources mis en oeuvre avec un dispositif de contrôle-commande de l'invention, dans un mode de réalisation préférentiel ;
- la figure 4 est un organigramme illustrant un procédé d'alimentation du dispositif de contrôle-commande d'un inverseur de sources.

### DESCRIPTION DETAILLEE DE MODES DE REALISATION PREFERES

Dans la description, le terme « une source est disponible » sera utilisé pour qualifier une source en capacité de délivrer de l'énergie électrique. Une source peut délivrer une énergie électrique sous forme polyphasée, et dans ce cas généralement triphasée, ou encore monophasée ou continue.
Le terme «commutateur » sera utilisé pour dénommer préférentiellement un disjoncteur électrique mais peut aussi dénommer un contacteur, une des voies d'un contacteur double, un relais ou encore un interrupteur électronique statique à semi-conducteurs.
Le terme «connexion amont » sera utilisé pour dénommer une liaison vers une source d'énergie, le terme «connexion aval » sera utilisé pour dénommer une liaison vers un récepteur d'énergie.

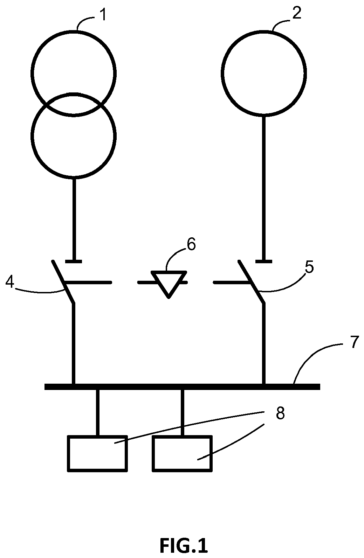

La figure 1 est une représentation schématique classique d'une installation électrique comportant un inverseur de sources. Une source principale 1 fournit l'énergie électrique à une ou plusieurs charges 8. Une charge 8 peut être un équipement ou un ensemble de plusieurs équipements dont le fonctionnement ne doit pas être interrompu, une zone technique contenant des équipements devant être alimentés en permanence ou un bâtiment dont l'alimentation en énergie présente un aspect vital. Un commutateur 4, connecté en amont à la source 1 et en aval à un jeu de barre 7, établit la liaison entre la source 1 et le jeu de barre 7. La charge 8 est connectée au jeu de barre 7. Le commutateur 4 peut être un contacteur, un relais, un disjoncteur.
En cas d'indisponibilité de la source principale 1, par exemple suite à une rupture de câble ou un court-circuit en amont de l'installation, une seconde source 2 d'énergie électrique est utilisée pour continuer à alimenter la charge 8. Cette seconde source pourra être un générateur local tel qu'un groupe électrogène. Un commutateur 5, connecté en amont à la seconde source 2 et en aval au jeu de barre 7, établit la liaison entre la seconde source 2 et le jeu de barre 7.
Il peut arriver que la première source 1 et la seconde source 2 soient disponibles simultanément. Ces deux sources ne sont généralement pas synchronisées et donc n'étant pas en phase entre elles, il est impératif qu'elles ne soient pas connectées simultanément sur le jeu de barre 7. Un des rôles de l'inverseur de sources et d'éviter cette situation. Pour cela un dispositif d'inter-verrouillage 6 empêche la fermeture d'un commutateur si l'autre commutateur est déjà fermé. En revanche, les deux commutateurs peuvent être ouverts simultanément, séparant ainsi le jeu de barre de chaque source d'énergie, par exemple pour effectuer des opérations de maintenance sur la charge.

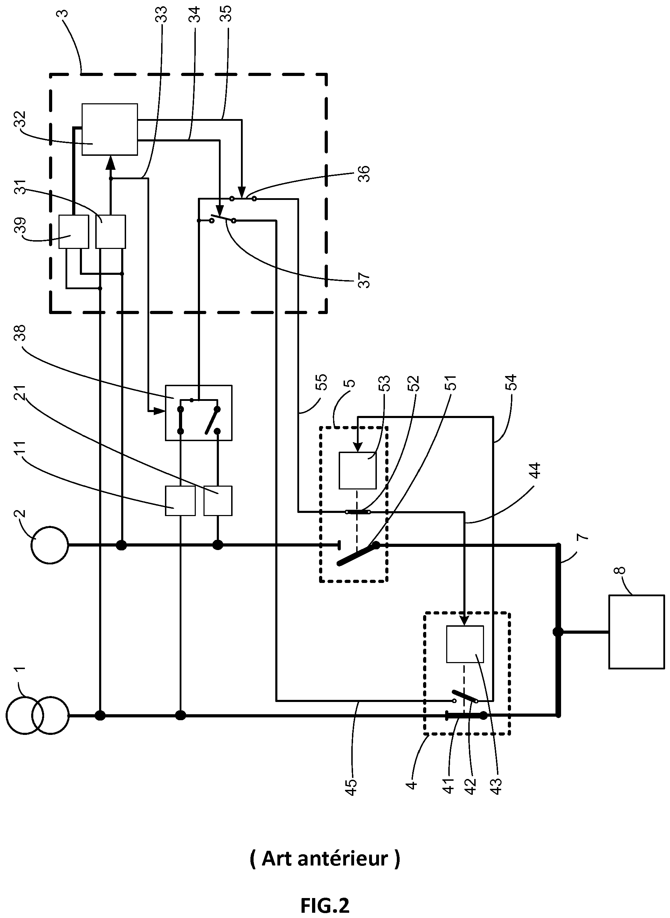

La figure 2 est une représentation schématique d'un dispositif inverseur de sources tel que décrit dans l'art antérieur. Un dispositif 3 est destiné au contrôle-commande des commutateurs 4 et 5. Le dispositif 3 est alimenté à partir des sources d'énergie 1 et 2 au moyen d'une alimentation 39. Cette alimentation de faible puissance est reliée aux sources d'énergie 1 et 2 et prélève l'énergie sur chacune des sources par exemple au travers de redresseurs à semi-conducteurs suivis par une régulation de tension, non représentés sur la figure 2. Un circuit 31 fournit l'information concernant la ou les sources disponibles à un circuit de pilotage 32 et à un inverseur de source auxiliaire 38 au moyen d'une liaison 33. Ledit inverseur de sources auxiliaire est connecté en amont aux sources 1 et 2 et en aval aux contacts 36 et 37. Sa fonction est de sélectionner la source d'alimentation disponible afin de prélever l'énergie nécessaire à l'activation des commutateurs 4 et 5, sans créer de liaison électrique entre les sources 1 et 2. Un dispositif de protection contre les surintensités 11, tel qu'un disjoncteur, protège la liaison électrique entre la source 1 et l'inverseur de sources 38 contre toute surintensité liée à un court-circuit au niveau de l'inverseur de source 38 ou en aval de celui-ci. De même, un dispositif de protection contre les surintensités 21 protège la liaison électrique entre la source 2 et l'inverseur de sources 38 contre toute surintensité liée à un court-circuit au niveau de l'inverseur de source 38 ou en aval de celui-ci.
Un dispositif tel que l'alimentation 39 n'est pas utilisable pour commander l'activation des commutateurs, la puissance demandée étant trop importante, par exemple lorsque les commutateurs 4 et 5 sont des disjoncteurs de forte puissance.
La fonction du circuit de pilotage 32 est de commander les contacts 36 et 37 en fonction de l'information sur la disponibilité des sources 1 et 2 délivrée par le circuit 31.

Le commutateur 4 est composé d'un jeu de contacts 41 pour établir la liaison entre la source 1 et le jeu de barre 7 quand les contacts 41 sont fermés et pour ouvrir ladite liaison quand les contacts 41 sont ouverts. Un auxiliaire de commande 43 commande la fermeture et l'ouverture des contacts 41 en transformant une commande reçue par la liaison 44 en action pour l'ouverture et la fermeture des contacts 41. Au moins un capteur d'état 42 donne une information sur l'état ouvert ou fermé du contact 41. Généralement ce capteur d'état est un contact électrique dit «contact auxiliaire». Il est lié mécaniquement aux contacts 41 et n'a aucune liaison électrique avec les contacts 41 ou avec l'auxiliaire de commande 43. Préférentiellement, le contact électrique du capteur d'état est fermé quand les contacts 41 sont ouverts, et ouvert quand les contacts 41 sont fermés, tel que représenté sur la figure 2.
De même, le commutateur 5 est composé d'un jeu de contacts 51 pour établir la liaison entre la source secondaire 2 et le jeu de barre 7 quand les contacts 51 sont fermés et pour ouvrir ladite liaison quand les contacts 51 sont ouverts. Un auxiliaire de commande 53 commande la fermeture et l'ouverture des contacts 51 en transformant une commande reçue par la liaison 54 en action pour l'ouverture et la fermeture des contacts 51. Au moins un capteur d'état 52 donne une information sur l'état ouvert ou fermé du contact 51. De même que le capteur 42, ce capteur d'état est un contact électrique dit «contact auxiliaire». Il est lié mécaniquement aux contacts 51 et n'a aucune liaison électrique avec les contacts 51 ou avec l'auxiliaire de commande 53. Préférentiellement, le contact électrique dudit capteur d'état est fermé quand les contacts 51 sont ouverts, tel que représenté sur la figure 2, et ouvert quand les contacts 51 sont fermés.
Pour des raisons de clarté de la figure 2, la liaison entre la source 1 et le jeu de barre 7 ou la liaison entre la source 2 et le jeu de barre 7 sont représentées sous forme d'une ligne de courant. Dans le cas d'un réseau triphasé, cette ligne est constituée généralement de quatre lignes conductrices correspondant aux trois phases et au conducteur de neutre. Le jeu de contacts 41 comporte alors quatre contacts. De même, le jeu de contacts 51 comporte quatre contacts. D'autres variantes sont possibles : pour un réseau monophasé le jeu de contacts comportera deux contacts, pour un réseau triphasé sans neutre le jeu de contacts comportera trois contacts.

Les capteurs d'état 42 et 52 sont préférentiellement des composants électromécaniques. Ils peuvent être aussi réalisés par des dispositifs comportant de l'électronique : capteurs de la position des contacts 41, 51 à détection optique ou magnétique et sortie de l'information de position sous forme « tout ou rien » au moyen de relais électromécanique, de contacts électroniques statiques ou d'un bus de communication numérique.
Le contact 36 est relié par la liaison 55 au capteur d'état 52, lui-même relié par la liaison 44 à l'auxiliaire de commande 43 du commutateur 4.
De la même façon, le contact 37 est relié par la liaison 45 capteur d'état 42, lui-même relié par la liaison 54 à l'auxiliaire de commande 53 du commutateur 5.
La fermeture du contact 36 commande l'alimentation de l'auxiliaire de commande 43, lié au contact 41 du commutateur 4 pour actionner la fermeture du contact 41, quand le capteur d'état 52 est fermé. Ainsi, la liaison entre la source 1 et le jeu de barre 7 est établie par le contact 41, la charge 8 est alimentée en énergie. Quand le contact 52 est ouvert, correspondant à un contact 51 fermé, la fermeture du contact 36 n'a pas d'effet sur le contact 41. Il n'est donc pas possible de fermer simultanément les contacts 41 et 51 ce qui constitue un inter-verrouillage électrique des commutateurs 4 et 5.
De la même façon, la fermeture du contact 37 commande l'alimentation de l'auxiliaire de commande 53 lié mécaniquement au contact 51 du commutateur 5 pour actionner la fermeture du contact 51 quand le contact 41 est ouvert. Ainsi, la liaison entre la source 2 et le jeu de barre 7 est établie, la charge 8 est alimentée en énergie.
Ainsi que représenté figure 2, dans le cas ou la source principale 1 est disponible, le circuit de pilotage 32 envoie un ordre de fermeture du contact 36 et un ordre d'ouverture du contact 37. L'inverseur de source auxiliaire 38 réalise la liaison entre la source 1 et un point commun des contacts 36 et 37. Ainsi, l'ordre de fermeture du contact 36 aura pour effet d'alimenter l'auxiliaire de commande 43 du commutateur 4 et d'activer la fermeture du commutateur 4 alors que l'ordre d'ouverture du contact 37 aura pour effet de couper l'alimentation de l'organe électromécanique 53 du commutateur 5 et d'ouvrir le commutateur 5. La charge 8 connectée au jeu de barre 7 sera alimentée par la source 1. La source 2 sera isolée, non reliée au jeu de barre 7.
En cas de non disponibilité de la source 1, et si la seconde source 2 est disponible, le circuit de pilotage 32 commande l'ouverture du contact 36 et la fermeture du contact 37. Ainsi le commutateur 4 sera ouvert et le commutateur 5 sera fermé, la charge 8 connectée au jeu de barre 7 sera alimentée par la source secondaire 2. La source 1 sera isolée, non reliée au jeu de barre 7.
En cas de non disponibilité des deux sources, l'alimentation 39 ne dispose pas de source d'énergie, le dispositif de contrôle-commande 3 ne fonctionne pas, les contacts 36 et 37 sont ouverts et par conséquent les commutateurs 4 et 5 sont ouverts, la charge 8 n'est pas alimentée.

Un inverseur de source étant un dispositif utilisé en situation d'urgence pour fournir une alimentation de secours à une charge critique, son fonctionnement doit être très sûr. En particulier, la source 1 et la source secondaire 2 ne doivent généralement pas être reliées simultanément au jeu de barre 7. La représentation schématique de la figure 2 illustre ainsi un mode particulier d'inter-verrouillage électrique simple, nécessitant des moyens de traitement de données réduits dans le circuit de pilotage 32.

Ce type d'inverseur de source présente cependant des inconvénients :
- l'utilisation de plus de deux sources d'énergie complexifie rapidement le schéma de câblage. En effet, dans le cas où on dispose de n sources, il faut mettre en série n-1 capteurs d'état 42, 52 afin de permettre la fermeture d'un seul contact 41, 51 uniquement lorsque tous les autres sont ouverts. Cette complexité se manifeste par un câblage important,
- l'alimentation des organes de commande 43, 53 étant prélevée directement sur la liaison avec la source principale 1 et secondaire 2, toute variation de tension ou perturbation sera répercutée sur l'auxiliaire de commande. En particulier, la seconde source 2 étant souvent un groupe électrogène pouvant avoir une vitesse de rotation fluctuante en fonction de sa charge et de la qualité de sa régulation, la tension délivrée peut être en dehors de la spécification de l'auxiliaire de commande. Un auxiliaire étant alimenté dans une plage de tension en dehors de sa spécification peut être endommagé ou avoir un fonctionnement inefficace, et enfin
- l'isolement électrique entre les deux sources 1, 2 peut être rompu par un défaut d'isolement au niveau des contacts dans l'inverseur de source auxiliaire 38 ou encore par un défaut de synchronisation de fermeture desdits contacts peut être à l'origine d'un court-circuit entre la source 1 et la seconde source 2. Pour éliminer ce risque, des moyens de protection 11 et 21, tels que des disjoncteurs ou des fusibles, doivent être mis en oeuvre. Cela augmente le coût et le câblage de l'inverseur de sources.

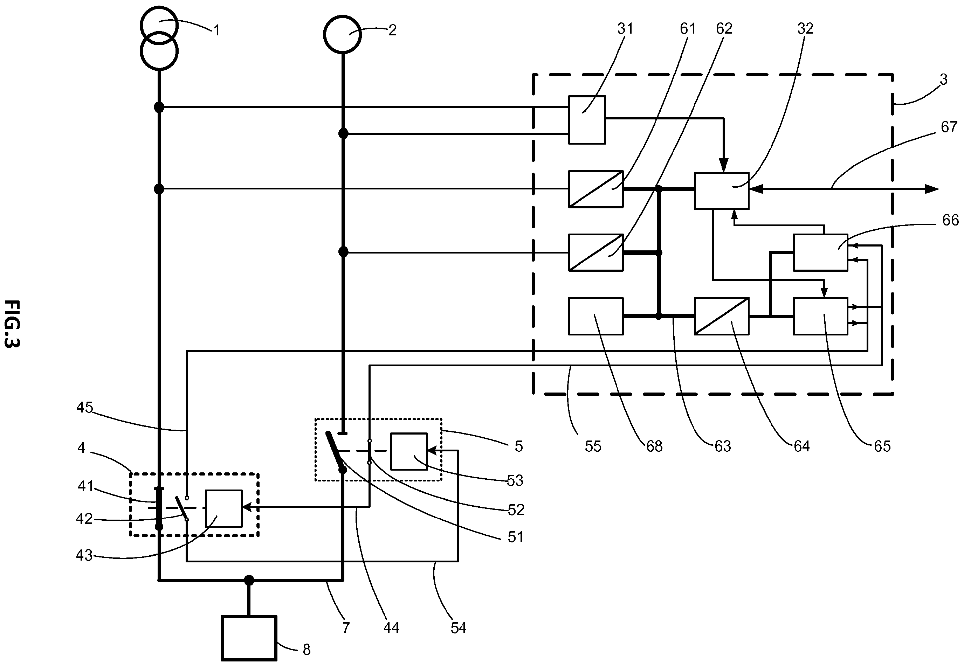

La figure 3 est une représentation schématique d'un dispositif inverseur de sources mis en oeuvre avec un dispositif de contrôle-commande 3 de l'invention, dans un mode de réalisation préférentiel.
Un convertisseur de tension AC/DC 61 est connecté entre la source 1 et un bus d'alimentation 63. Ce convertisseur transforme une première tension Us1 générée par la source 1, par exemple 400 Volt 50 Hz, appliquée à son entrée, en une tension intermédiaire Ui, délivrée par sa sortie au bus d'alimentation 63, par exemple 24 Volt, cette valeur étant donnée à titre d'exemple nullement limitatif. Le convertisseur de tension AC/DC 61 est un composant autonome qui effectue la conversion de tension dès que la première tension Us1 appliquée à son entrée dépasse un premier seuil minimal Us1_mini, par exemple Us1_mini = 50 Volt.
Un second convertisseur de tension AC/DC 62 est connecté entre la source secondaire 2 et le bus d'alimentation 63.
De façon identique au convertisseur 61, le second convertisseur de tension 62 transforme une seconde tension Us2 générée par la source secondaire 2, appliquée à son entrée, en une tension intermédiaire, Ui, délivrée par sa sortie au bus d'alimentation 63. Il effectue, de manière autonome, la conversion de tension dès que la seconde tension Us2 dépasse un second seuil minimal Us2_mini. Selon un mode de réalisation préférentiel, la première tension Us1 et la seconde tension Us2 sont des tensions alternatives, la tension intermédiaire Ui est une tension continue.

Les valeurs des seuils de tension Us1_mini et Us2_mini en entrée des convertisseurs de tension 61 et 62 sont indépendantes entre elles. Pour des raisons pratiques, les convertisseurs AC/DC 61 et 62 étant de préférence identiques, les première et seconde tensions Us1 et Us2 étant d'amplitude généralement proche, le seuil Us2_mini est préférentiellement sensiblement égal au seuil Us1_mini.
Avantageusement les convertisseurs de tension 61 et 62 sont dimensionnés pour fonctionner sur une grande dynamique de tension d'entrée Us1 et Us2 afin de permettre une installation du dispositif inverseur de source dans des conditions très variées d'utilisation sans nécessiter d'adaptation particulière ni un important nombre de variantes industrielles. La plage de tension Us1 ou Us2 acceptable par les convertisseurs de tension AC/DC 61 ou 62 est, par exemple, de 60 Volt à 600 Volt. De plus les convertisseurs de tension 61 et 62 sont agencés selon la technique connue pour fonctionner sans modification dans une installation électrique dont les sources 1 et 2 ont une fréquence comprise entre quelques Hertz et plusieurs centaines de Hertz, par exemple de 16,33Hz jusqu'à 400 Hz.

Avantageusement chaque convertisseur de tension 61, 62 dispose d'une isolation galvanique interne entre son entrée et sa sortie. Cette isolation est réalisée généralement par un transformateur. Il n'y a aucune liaison directe entre l'entrée et la sortie du convertisseur, le transfert de l'énergie se faisant par échange de flux magnétique dans le transformateur. Le risque de liaison électrique accidentelle entre les sources 1 et 2 est ainsi extrêmement réduit.

Le bus d'alimentation 63 fournit préférentiellement une alimentation au circuit de pilotage 32. Ledit circuit de pilotage 32 est connecté à des circuits de contrôle-commande 65, 66 pour commander les commutateurs 4 et 5 en fonction de la disponibilité des sources 1 ou 2 et contrôler si les commandes ont été effectuées correctement. En option, le circuit de pilotage 32 peut comporter une liaison de communication 67 destinée à la communication d'information d'état ou la réception de commande à partir d'un dispositif externe par exemple un superviseur. Cette liaison 67 est particulièrement utile pour diagnostiquer une anomalie de fonctionnement en permettant une remontée des informations de disponibilité des sources 1, 2 et des capteurs d'état 42, 52.
L'entrée d'un convertisseur de tension DC/AC 64 est connectée au bus d'alimentation 63. Le convertisseur de tension 64 transforme la tension intermédiaire Ui, présente sur son entrée, en une tension d'utilisation Uc pour alimenter les circuits de contrôle-commande. Le convertisseur de tension 64 effectue la conversion de tension dès que la tension intermédiaire Ui est présente sur son entrée.

La tension d'utilisation Uc est indépendante des tensions Us1, de Us2 ou Ui, la valeur de l'amplitude de la tension Uc peut donc être choisie librement.
Dans la pratique, c'est la tension nominale de fonctionnement choisie pour les circuits de contrôle-commande qui fixe l'amplitude de la tension d'utilisation Uc que fournit le convertisseur de tension, de préférence parmi des valeurs communément utilisées en Europe ou aux Etats-Unis ou en lien avec des habitudes locales. Par exemple, une tension d'utilisation Uc d'amplitude 240 Volt et de fréquence 50 Hz convient à de nombreux circuits de contrôle-commande en Europe et en Chine, en particulier pour les auxiliaires de commande 43, 53 ou les capteurs d'état 42, 52. Une tension d'utilisation Uc d'amplitude 400 Volt et de fréquence 50 Hz est aussi très répandue en milieu industriel. Pour le marché des Etats-Unis, une tension d'utilisation d'amplitude 120 Volt et de fréquence 60 Hz conviendra parfaitement. Ainsi le coût et la disponibilité des circuits de contrôle-commande est optimal parce que ces circuits seront largement répandus. Pour autant, l'utilisation du convertisseur de tension DC/AC 64 permet de prendre en compte des spécificités locales de l'installation électrique. Il est ainsi possible de fournir une autre amplitude de tension et une autre fréquence sans avoir à changer de convertisseur de tension 64 : le paramétrage du convertisseur pour définir l'amplitude et la fréquence de la tension d'utilisation Uc peut être effectué par exemple en usine, lors de la fabrication de l'inverseur de sources ou lors de la mise en oeuvre sur site.

L'utilisation du convertisseur DC/AC 64 permet de garantir une tension et une fréquence stable de la tension d'utilisation Uc indépendamment des fluctuations des tensions Us1 ou Us2 délivrées par les sources 1 ou 2. Ainsi les circuits de contrôle-commande fonctionnent dans la plage nominale de tension pour laquelle ils sont conçus. Le risque de dysfonctionnement desdits circuits ayant pour cause un fonctionnement hors spécification est donc éliminé. Il est par ailleurs possible d'utiliser des circuits de contrôle-commande dont les plages de tension d'alimentation sont réduites et donc des circuits moins coûteux.

Les circuits de contrôle-commande comportent :
- un circuit 65 de commande de l'activation des commutateurs et/ou
- un circuit 66 de contrôle de l'état des commutateurs et/ou
- un circuit 31 de détermination de la disponibilité des sources.
Le circuit 65 commande l'activation des commutateurs 4 et 5. Il est connecté en amont au circuit de pilotage 32 pour recevoir des ordres d'ouverture ou de fermeture des commutateurs 4 et 5 et en aval aux liaisons 45 et 55.
Une commande d'activation du commutateur 4 issue du circuit 65 est acheminée par la liaison 55 vers le capteur d'état 52. Quand le capteur d'état 52 est fermé, la commande est acheminée par la liaison 44 à l'auxiliaire de commande 43 du commutateur 4. Une commande d'activation du commutateur 5 suivra un chemin semblable par la liaison 45, le capteur d'état 42, la liaison 54 et l'auxiliaire de commande 53.
De la même façon que sur la figure 2, les commutateurs 4 et 5 sont inter-verrouillés.
Le circuit 65 est connecté en aval du convertisseur DC/AC 64 pour son alimentation. Il reçoit une tension Uc.
Le circuit 66 est destiné à contrôler l'état des capteurs d'état 42 et 52. Il est connecté en amont au circuit de pilotage 32 et connecté en aval aux capteurs d'état 42 et 52. Dans un mode de réalisation préférentiel, le circuit 66 polarise les capteurs d'état 42 et 52 des commutateurs 1 et 2 afin de déterminer si lesdits contacts sont ouverts ou fermés et transmet l'état des capteurs d'état au circuit de pilotage 32.
Le circuit de contrôle d'état 66 peut comporter d'autres entrées : par exemple, lorsque les commutateurs 4, 5 sont des disjoncteurs de puissance débrochables, le circuit 66 peut comporter des entrées relatives à l'état embroché ou débroché, l'état armé ou déclenché des commutateurs 4,5.
Le circuit 66 est connecté en aval du convertisseur DC/AC 64 pour son alimentation. Il reçoit une tension Uc.
Pour des raisons d'économie de fabrication et/ou de rationalisation des fonctions, les circuits 65 et 66 peuvent être disposés dans un module unique, connecté en aval du convertisseur DC/AC 64 par une seule liaison pour son alimentation.
Le circuit 31 fournit l'information sur la disponibilité des sources 1, 2 au circuit de pilotage 32. Il peut recevoir son alimentation du bus d'alimentation 63 ou être connecté en aval du convertisseur DC/AC 64. Dans un mode de réalisation préférentiel, le circuit 31 tire son énergie directement des sources 1 et 2 auxquelles il est relié, tel que représenté sur la figure 3.

En option, un dispositif d'alimentation de secours 68 est connecté au bus d'alimentation afin de délivrer de l'énergie au bus d'alimentation 63 quand la première et la seconde source d'énergie 1, 2 sont indisponibles. Le dispositif d'alimentation 68 est composé préférentiellement d'un moyen de stockage d'énergie électrique tel qu'une batterie ou un ensemble de condensateurs, non représenté sur la figure 3. Il comporte des circuits de recharge pour recharger en énergie le moyen de stockage, sous une tension de stockage Ust, lorsque au moins l'un des convertisseurs 61, 62 est en fonctionnement. Il comporte également des circuits permettant de détecter l'absence de tension intermédiaire Ui sur le bus d'alimentation quand les deux convertisseurs 61 et 62 ne sont pas en fonctionnement et des circuits pour délivrer, dans ce cas, une tension intermédiaire Ui au bus d'alimentation en prélevant l'énergie nécessaire dans le moyen de stockage d'énergie.
La tension intermédiaire Ui est indépendante des tensions des sources Us1, Us2 et de la tension d'utilisation Uc. La tension intermédiaire Ui peut donc être choisie librement. De préférence, elle est fixée à une valeur permettant de rendre la conception simple. Dans le cas où un dispositif d'alimentation de secours 68 est connecté au bus d'alimentation 63, il est intéressant de fixer la tension Ui à une valeur sensiblement égale à la tension nominale de stockage Ust du moyen de stockage d'énergie du dispositif de secours 68. Par exemple Ust = 24 Volt ou 48 Volt qui sont des tensions classiquement employées pour des moyens de stockage utilisant une ou plusieurs batteries montées en série. En l'absence d'un dispositif d'alimentation de secours 68, la tension intermédiaire Ui peut être fixée pour être adaptée à l'alimentation du circuit de pilotage 32, par exemple 5 ou 12 Volt. De manière plus générale, plus la tension intermédiaire Ui sera élevée, plus le courant dans le bus d'alimentation 63 sera faible. L'énergie perdue par effet Joule sera moins importante.
Préférentiellement, le circuit de pilotage 32 comporte une interface homme-machine permettant à un opérateur d'effectuer toute opération de contrôle ou de commande de l'inverseur de sources, par exemple en phase de maintenance. Avantageusement, quand aucune source n'est disponible et qu'il existe un dispositif d'alimentation de secours 68, un opérateur peut visualiser l'état de disponibilité des premières et secondes sources 1 et 2 donné par le circuit 31 et l'état des commutateurs 4 et 5 donné par le circuit 66 de contrôle d'état pour apporter un diagnostic.
En variante, les convertisseurs de tension AC/DC 61, 62 peuvent fournir directement au circuit de pilotage 32 l'information de disponibilité des sources 1, 2 au moyen d'une liaison directe, non représentée sur la figure 3. Le circuit 31 de détermination de la disponibilité des sources n'est ainsi plus nécessaire, le coût du circuit de pilotage 32 est diminué.

L'architecture du dispositif de contrôle-commande 3 tel que présenté dans la figure 3 présente plusieurs avantages :
- le dispositif de contrôle-commande 3 peut aisément être adapté à une configuration ayant n sources, par ajout d'autant de convertisseurs de tension AC/DC 61, 62 que de sources supplémentaires 1, 2 ;
- l'isolement galvanique est assuré entre les auxiliaires de commande, les circuits de contrôle-commande et les sources ;
- les auxiliaires de commande sont alimentés par une tension d'utilisation Uc indépendante des première et seconde tensions source Us1 et Us2. La tension de fonctionnement des auxiliaires de commande peut donc être uniformisée ce qui permet une réduction du nombre de variante d'auxiliaire de commande conduisant à une économie sur le coût du produit ;
- la tension d'utilisation Uc est indépendante de l'une des tensions Us1 ou Us2 des sources ou de la composante desdites tensions Us1 ou Us2 ou encore de la tension intermédiaire Ui. Cet avantage est particulièrement intéressant en régime de distribution d'énergie triphasée, quand le neutre n'est pas distribué en aval des sources 1 et 2. Contrairement au dispositif décrit dans l'art antérieur illustré en figure 2, il est possible d'alimenter les circuits de contrôle-commande sous une tension égale à la tension simple : pour illustrer cet avantage, quand Us1 et Us2 sont égales à 400 Volt entre phases, la tension d'utilisation Uc peut être fixée à 240 Volt. Cet avantage permet d'utiliser des circuits de contrôle ayant une tension d'alimentation de 240 Volt, moins coûteux et plus répandus que des circuits équivalents fonctionnant sous une tension de 400 Volt. Cette configuration est impossible à réaliser avec le dispositif de l'art antérieur puisque les connexions pour l'alimentation des auxiliaires de commande 43 et 53 sont directement issues des sources et donc sans possibilité de connexion à une liaison de neutre quand celle-ci n'existe pas.

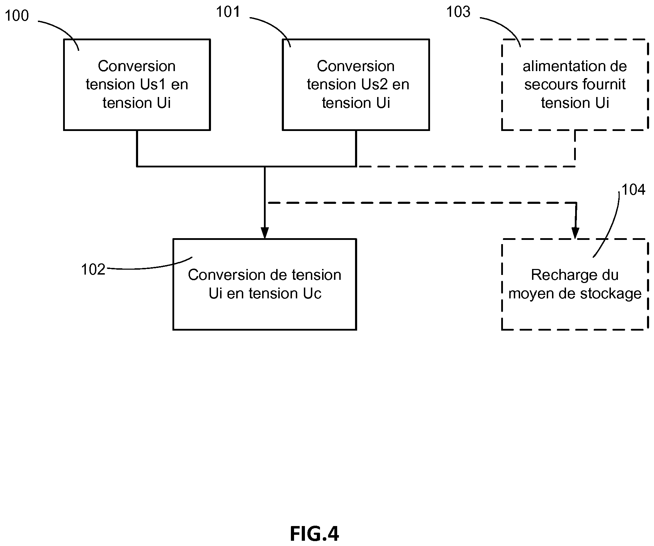

La figure 4 est un organigramme d'un procédé d'alimentation du dispositif 3 destiné au contrôle-commande d'un inverseur de sources.

Une étape 100 consiste à convertir la première tension Us1 de la première source d'énergie 1 en tension intermédiaire Ui pour alimenter le bus d'alimentation 63 au moyen d'un premier convertisseur de tension 61.
Parallèlement une étape 101 consiste à convertir la seconde tension Us2 de la seconde source d'énergie en tension intermédiaire Ui pour alimenter le bus d'alimentation 63 au moyen d'un deuxième convertisseur de tension 62.
A la suite de l'une ou l'autre des étapes précédentes, une étape 102 consiste à convertir la tension intermédiaire Ui du bus d'alimentation 63 en une tension d'utilisation Uc.

Quand la première source d'énergie 1 et la seconde source d'énergie 2 sont indisponibles et en l'absence de dispositif d'alimentation de secours 68, l'étape 102 n'est pas exécutée, la tension d'utilisation Uc n'est donc pas fournie.

Quand un dispositif d'alimentation de secours 68 est présent, deux cas de figure se présentent :
- l'étape 103 est exécutée quand la tension intermédiaire Ui n'est pas délivrée par conversion d'une des première ou seconde tension, Us1 ou Us2 : le dispositif d'alimentation de secours 68 fournit une tension intermédiaire Ui disponible sur le bus d'alimentation 63 et l'étape 102 peut être exécutée,
- quand la tension intermédiaire Ui est délivrée par conversion d'une des première ou seconde tension Us1 ou Us2, l'étape 102 est exécutée et parallèlement l'étape 104 est exécutée : le dispositif d'alimentation de secours 68 recharge ses moyens de stockage en prélevant l'énergie sur le bus d'alimentation 63.

## Revendications

1. Dispositif (3) destiné au contrôle-commande d'au moins un premier et un second commutateurs (4, 5) agencés pour connecter respectivement au moins une première (1) et une seconde (2) source d'énergie électrique à une charge électrique (8) en fonction de la disponibilité desdites sources, ledit dispositif comportant un circuit de pilotage (32) et des circuits de contrôle-commande, **caractérisé en ce qu'**il comprend :
- un bus d'alimentation (63),
- un premier convertisseur de tension (61) comportant une entrée reliée à la première source d'énergie (1) et une sortie connectée au bus d'alimentation (63), et agencé pour convertir une première tension (Us1) de la première source d'énergie en une tension intermédiaire (Ui) pour alimenter le bus d'alimentation (63),
- un deuxième convertisseur de tension (62) comportant une entrée reliée à la seconde source d'énergie (2) et une sortie connectée au bus d'alimentation (63), et agencé pour convertir une seconde tension (Us2) de la seconde source d'énergie (2) en une tension intermédiaire (Ui) pour alimenter le bus d'alimentation (63),
- un troisième convertisseur de tension (64) agencé pour convertir la tension intermédiaire (Ui) du bus d'alimentation (63) en une tension d'utilisation (Uc) pour alimenter les circuits de contrôle-commande.

2. Dispositif selon la revendication 1 **caractérisé en ce que** les circuits de contrôle-commande comportent :
- un circuit (65) de commande de l'activation des commutateurs et/ou
- un circuit (66) de contrôle de l'état des commutateurs et/ou
- un circuit (31) de détermination de la disponibilité des sources.

3. Dispositif selon la revendication 1 **caractérisé en ce que** les premier et deuxième moyens de conversion (61, 62) comportent une isolation galvanique respectivement entre la première source d'énergie électrique (1) et le bus d'alimentation (63), et entre la seconde source d'énergie électrique (2) et le bus d'alimentation (63).

4. Dispositif selon l'une des revendications précédentes **caractérisé en ce que** le premier convertisseur de tension (61) effectue la conversion de la première tension (Us1) de la première source d'énergie en une tension intermédiaire (Ui) lorsque la première tension (Us1) est supérieure à un premier seuil (Us1_mini) et que le deuxième convertisseur de tension (62) effectue la conversion de la seconde tension (Us2) de la seconde source d'énergie en ladite tension intermédiaire (Ui) lorsque la seconde tension (Us2) est supérieure à un second seuil (Us2_mini).

5. Dispositif selon l'une des revendications précédentes **caractérisé en ce que** la tension intermédiaire (Ui) est une tension continue.

6. Dispositif selon l'une des revendications précédentes **caractérisé en ce que** la tension d'utilisation (Uc) est sensiblement égale à la tension nominale de fonctionnement des circuits de contrôle-commande.

7. Dispositif selon l'une des revendications précédentes **caractérisé en ce qu'**un dispositif d'alimentation de secours (68) est connecté au bus d'alimentation pour délivrer la tension intermédiaire (Ui) audit bus d'alimentation quand la première et la seconde source d'énergie (1, 2) sont indisponibles.

8. Dispositif selon la revendication 7 **caractérisé en ce que** le dispositif d'alimentation de secours (68) comporte un moyen de stockage d'énergie agencé pour être chargé sous une tension de stockage (Ust) quand la première et/ou la seconde source d'énergie (1, 2) est disponible.

9. Dispositif selon l'une des revendications précédentes **caractérisé en ce que** la tension intermédiaire (Ui) est sensiblement égale à la tension de stockage (Ust) du moyen de stockage d'énergie du dispositif de secours (68).

10. Dispositif selon l'une des revendications précédentes **caractérisé en ce que** le circuit de pilotage (32) est connecté au bus d'alimentation (63) pour son alimentation.

11. Inverseur de sources destiné à connecter respectivement une première ou une seconde source d'énergie électrique (1, 2) à une charge électrique (8) en fonction de la disponibilité desdites sources, ledit inverseur de source comportant :
- au moins un premier et un second commutateurs (4, 5),
- au moins deux auxiliaires de commande (43, 53), chaque auxiliaire étant destiné à commander respectivement un commutateur (4, 5), et
- un ou plusieurs capteurs d'état (42, 52), chaque capteur d'état coopérant respectivement avec un commutateur (4, 5) pour détecter l'état dudit commutateur,
**caractérisé en ce qu'**il comporte un dispositif de contrôle-commande selon l'une des revendications 1 à 10.

12. Inverseur de sources selon la revendication 11, **caractérisé en ce que** l'entrée des premiers moyens de conversion (61) est connectée entre la première source (1) et le premier commutateur (4), et que l'entrée des seconds moyens de conversion (62) est connectée entre la seconde source (2) et le second commutateur (5).

13. Procédé pour l'alimentation d'un dispositif destiné au contrôle-commande d'un inverseur de sources selon l'une des revendications 11 ou 12 **caractérisé en ce qu'**il comprend les étapes suivantes :
- la conversion de la première tension (Us1) de la première source d'énergie (1) en tension intermédiaire (Ui) pour alimenter le bus d'alimentation (63) au moyen d'un premier convertisseur de tension (61),
- la conversion de la seconde tension (Us2) de la seconde source d'énergie (2) en tension intermédiaire (Ui) pour alimenter le bus d'alimentation (63) au moyen d'un deuxième convertisseur de tension (62),
- la conversion de la tension (Ui) du bus d'alimentation en une tension d'utilisation (Uc) au moyen d'un troisième convertisseur de tension.

14. Procédé pour l'alimentation d'un dispositif destiné au contrôle-commande d'un inverseur de sources selon la revendication 13 **caractérisé en ce qu'**il comprend les étapes suivantes en cas de présence d'un dispositif d'alimentation de secours (68) :
- la fourniture par le dispositif d'alimentation de secours (68) de la tension intermédiaire (Ui) au bus d'alimentation (63) quand les deux moyens de conversion (61, 62) de la première tension (Us1) ou de la seconde tension (Us2) ne fonctionnent pas, sinon,
- la recharge du moyen de stockage du dispositif d'alimentation de secours (68) quand la tension intermédiaire (Ui) est fournie par au moins un des moyens de conversion (61, 62) de la première tension (Us1) ou de la seconde tension (Us2).
